Europäisches Patentamt

European Patent Office  (11) Publication number:  **0 142 842**
**A1**
Office européen des brevets

(12)  **EUROPEAN PATENT APPLICATION**

(21) Application number: **84113920.7**  (51) Int. Cl.⁴: **G 01 R 29/033**
**H 04 N 17/00**
(22) Date of filing: **17.11.84**

(30) Priority: **18.11.83 US 553348**

(43) Date of publication of application:
**29.05.85 Bulletin 85/22**

(84) Designated Contracting States:
**DE FR GB NL**

(71) Applicant: **TEKTRONIX, INC.**
**Tektronix Industrial Park D/S Y3-121 4900 S.W. Griffith**
**Drive P.O. Box 500**
**Beaverton Oregon 97077(US)**

(72) Inventor: **Plantenga, Todd D.**
**2110 Hobson Road Apt. C215**
**Fort Wayne Indiana 46805(US)**

(74) Representative: **Baillie, Iain Cameron et al,**
**c/o Ladas & Parry Isartorplatz 5**
**D-8000 München 2(DE)**

(54) Method of determining whether an acquired signal includes at least one predertermined signal element.

㉗ A method of determining whether an acquired signal includes at least one specific signal element, comprises identifying the relative time occurrences of transitions of the acquired signal through at least one predetermined signal level, and comparing the identified relative time occurrences with predetermined rules governing the relative time occurrences of transitions of the specific signal element through the predetermined signal level. If the identified relative time occurrences conform to the predetermined rules, an output signal is provided, indicating that the acquired signal includes the specific signal element.

FIG. I

## METHOD OF DETERMINING WHETHER AN ACQUIRED SIGNAL INCLUDES AT LEAST ONE PREDETERMINED SIGNAL ELEMENT

This invention relates to a method of determining whether an acquired signal includes at least one predetermined signal element, and may be used to determine whether the acquired signal is a standard test signal.

### Background of the Invention

It is well known to insert test signals on selected lines of the vertical interval of a television signal. So-called vertical interval test signals (VIT signals) are inserted in order to enable testing of the various elements of the signal chain, such as the transmitter, satellite communication links and microwave links. Each test signal includes one or more test signal elements, as defined in Annex 1 to Part C of CC1R Recommendation 567 (1978), such as the bar, step wedge and 10T composite chrominance pulse. The various signal elements are usually arranged in predetermined combinations. For example, the U.K. National test signal 1 comprises a bar, a 2T sine-squared luminance pulse, a 2T composite chrominance pulse and a chrominance staircase, the relative timing of the elements also being predetermined. Apparatus which performs automatic measurements on VIT signals is known, for example the Tektronix 1980 Automatic Video Measurement Set. The Tektronix 1980 operates by digitizing a selected line of the vertical interval and performing computations relating to the test signal using the digital information. However, although there is a certain amount of convention concerning the line of the vertical interval that is used for carrying a VIT signal, e.g., the multiburst signal is usually inserted on line 18 of the PAL signal, the conventions are not universally followed. Moreover, the test signals that are conventionally employed do not all have the identical signal elements in the same combination. For example, whereas the U.K. National test signal 1 comprises the elements referred to above, the so-called International test signal A comprises a bar, a 2T luminance pulse, a 20T composite chrominance pulse and a luminance staircase, and the International test signal B comprises a bar, a 2T luminance pulse and a chrominance staircase. Therefore, it is necessary to identify not only the line carrying the test signal but also the location in time with respect to sync of the various elements of the test signal in order for the measurement results to have meaning. The elements of the standard test signals are such that they can be identified by an experienced operator using a waveform monitor to examine the signal profile of each line of the vertical interval, and the operator is able to program the measurement apparatus to carry out the desired measurement on the line carrying the test signal, but the need for a human operator at least partially defeats the object of providing an automatic measurement apparatus. In addition, the signal elements of the standard test signals permit an automatic determination of whether an acquired signal is in fact a specific standard test signal by determining whether the acquired signal fits a template derived from the signal elements of the test signal. For example, in the PAL system utilizing a normalized 1 volt peak-to-peak baseband signal, the multiburst signal has a white flag which commences 12 μs after sync and ends 4 μs later and has an amplitude of 860 mv (sync tip being taken as zero volts); after the flag the signal remains at 440 mv until 20 μs after sync; whereafter the d.c. level of the signal increases to 650 mv and remains at that level until 62 μs after sync, having six distinct high frequency (0.5 MHz to 5.8 MHz) packets superimposed thereon; and the signal drops to blanking level and remains at blanking level for the last 2 µs before the next sync pulse. A template which distinguishes the multiburst signal from other standard test signals and, statistically, from teletext and normal video, might be based, for example, on a 860 mv level 14 µs after sync, a 440 mv level 18 µs after sync and a 650 mv level 22 µs after sync, and if it is found that voltage levels of the acquired signal on line 18 of the composite PAL signal satisfy these criteria (within statistical limits) the signal under investigation is assumed to be the multiburst signal. However, this method is subject to the disadvantage that noise on the signal may cause erroneous results to be provided. In addition, a template is not able to respond accurately to non-linearity in the amplification of the signal with respect to amplitude level, or timing shift of the test signal with respect to sync. Also, although the voltage levels of the test signal are referred to the normalized 1 volt peak-to-peak baseband signal, the voltage levels might be outside the expected range of values, for example owing to use of a step-function gain control to compensate for variation from the 1 volt peak-to-peak standard. Thus, in the Tektronix 1980 the input baseband signal is amplified only by discrete factors, and amplification is triggered only if the amplitude of the baseband signal differs by more than a predetermined amount from 1 volt.

## Summary of the Invention

According to the present invention there is provided a method of determining whether an acquired signal includes at least one predetermined signal element, comprising the steps of identifying the relative time occurrences of transitions of the acquired signal through at least one predetermined signal level, and comparing the identified relative time occurrences with predetermined rules governing the relative time occurrences of transitions of the signal element through said predetermined signal level.

The invention may be used to identify specific elements of an acquired signal by reference to transitions of the signal level which uniquely distinguish a specific standard test signal element from other standard test signal elements and which statistically distinguish the specific standard test signal element from active video. Identifying signal elements by reference to transitions immuinzes the identification process from errors which arise due to variations in the actual signal level at a particular point from its nominal level at that point.

In application of the invention to automatic measurement of video test signals, the acquired signal may be derived from the luminance component of the composite video signal or from the chrominance component of the composite video signal.

### Brief Description of the Drawings

For a better understanding of the invention, and to show how the same may be carried into effect, reference will now be made, by way of example, to the accompanying drawings in which:

FIG. 1 is a simplified flow chart illustrating the steps of a method embodying the invention;

FIGs. 2, 4 and 5 illustrate the waveforms of some test signals; and

FIG. 3 illustrates luminance and chrominance arrays derived from a 10T composite chrominance pulse.

## Detailed Description

In accordance with the preferred method embodying the invention, the active line period of a selected television line of the baseband PAL television signal, which has a duration of 64 µs, is sampled at intervals of 56.388 ns. However, while the line duration of 64 µs would yield 1135 samples if the entire line were sampled at intervals of 56.388 ns, only 963 samples are taken, commencing 9 µs after sync, so as to exclude sync and burst, and continuing until 63 µs after sync, so as to exclude the blanking immediately preceding sync. The samples are converted to 8 bit binary form. This sampling and digitizing is repeated for eight occurrences of the selected line on consecutive frames, with the sampling points on the different occurrences of the selected line being accurately controlled with reference to sync. Thus, eight arrays of 963 digital words, representing the composite video signal on eight consecutive occurrences of the selected video line, are obtained. Software operations are carried out on the composite video arrays to derive a luminance array and a chrominance array.

The luminance array is derived by averaging the eight digital words for each sampling position and carrying out a cosine low pass operation on the averaged array. In the PAL system, the phase of the subcarrier shifts on consecutive frames such that averaging the digital words for each sampling position over four consecutive frames results in cancellation of the chrominance subcarrier. (Averaging is carried out over eight consecutive frames instead of four just to obtain noise reduction.) Thus, the averaging effectively comb filters the eight composite arrays and eliminates information at the subcarrier frequency of

4.43 MHz. The cosine low pass operation, having a cutoff frequency below the frequency of the subcarrier, removes the chrominance sidebands and high frequency noise.

The chrominance array is obtained by carrying out a bandpass operation on each of the eight composite arrays in turn, and then averaging over the eight filtered arrays. The bandwidth and center frequency of the bandpass operation are chosen to eliminate luminance information without distorting the chrominance sidebands. Preferably, the bandpass operation also rectifies the chrominance component, and therefore the resulting chrominance array represents the envelope of the chrominance signal.

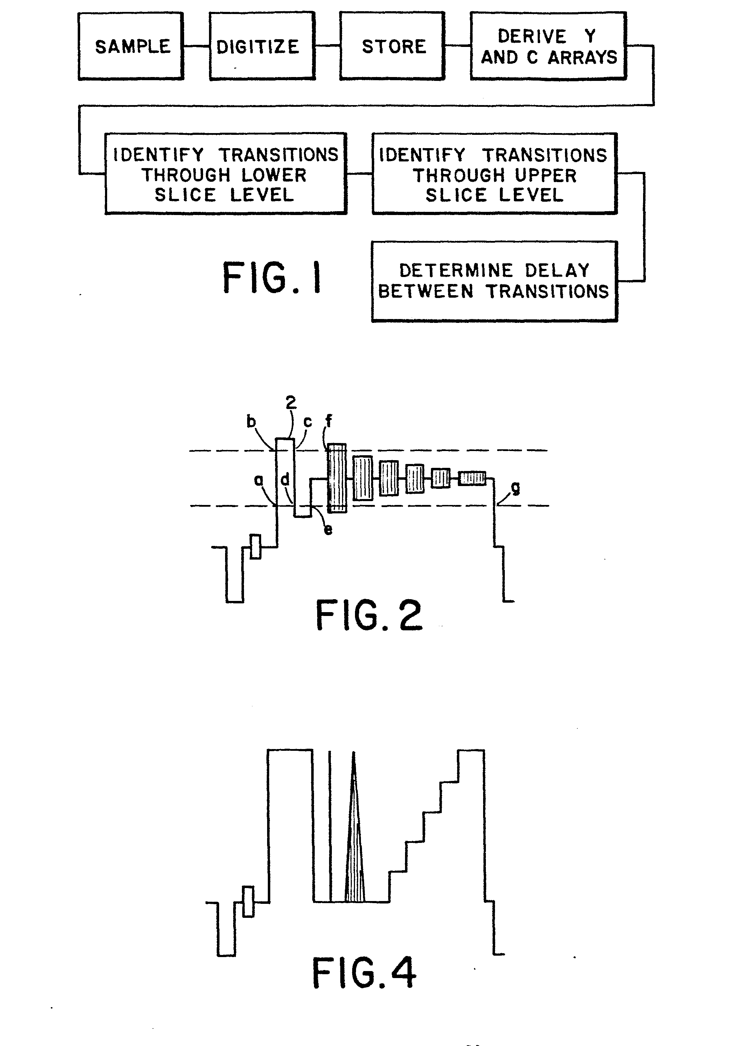

An additional software operation is used to compute the locations of transitions of the luminance and chrominance arrays through predetermined amplitude levels. It will be understood by those skilled in the art that the baseband video signals that are distributed about a studio or other production or distribution plant are normalized to a nominal 1 volt peak-to-peak amplitude, from sync tip to peak white, and that the standard test signals have predetermined amplitude profiles within the 1 volt peak-to-peak amplitude band. Each standard test signal can be characterized uniquely by the relative locations of transitions of the luminance array and/or the chrominance array through no more than two predetermined slice levels. The slice levels may be, for example, 200 mv and 500 mv. However, it is at present preferred that the slice levels be 250 mv and 450 mv. Each pair of arrays (luminance and chrominance) is scanned to determine whether the line represented by the two arrays includes signal elements which characterize uniquely a particular test signal. This is accomplished by identifying the transitions of the two arrays through the slice level(s) and examining the transitions to determine whether their relative locations on the preselected line characterize an element of a test signal. In a preferred embodiment of the invention, the luminance array transitions are first examined to determine whether discernible luminance information is present on the selected line. This is accomplished by establishing whether there are any transitions through the lower slice level. If there are no transitions through the lower slice level, the line is assumed to be quiet and is excluded from further examination. If the line is not quiet, the luminance array transitions are examined (by a method that is not part of this invention) to identify the number of transitions through a given slice level, and if the number of transitions exceeds a given threshold the line is assumed to be active video or teletext, i.e., not a standard test signal, and is excluded from further examination. If the line is not excluded by the first two tests, the luminance transitions are examined to determine whether the multiburst signal is present. The profile of the luminance array representing the multiburst test signal is as shown in FIG. 2 (ignoring the fact that the array does not cover the entire line), and comprises a flag 2 which commences 12 µ s after the leading edge of sync and has a duration of 4 µs, the flag 2 having an amplitude of 860 mV (taking sync tip as zero volts). After the flag 2, the signal remains at an amplitude of 440 mV for a further 4 µs, whereafter there is a succession of six distinct bursts 4 of 0.5 MHz, 1.0 MHz, 2.0 MHz, 4.0 MHz, 4.8 MHz and 5.8 MHz respectively, centered on a level of 650 mv. It will be noted that the burst are attenuated by the cosine low pass operation to an extent dependent on frequency. Nevertheless, the 0.5 MHz burst extends beyond the amplitude band defined between the two slice levels. In order to determine whether a given luminance array was derived from the composite multiburst signal, the luminance array transitions are examined. It will be seen from FIG. 2 that the leading edge of the flag will give rise to the transitions a and b through the lower and upper levels respectively, and that the transition from the 860 mV level to the 440 mV level will give rise to further transitions c and d through the upper and lower levels respectively. Following the flag 2, there will be a transition e through the lower level. The 0.5 MHz burst will give rise at least to the transition f through the upper level. Using a software routine designed in accordance with known principles, the transitions a, b, c, d, e, and f can be used to distinguish the multiburst signal from other standard test signals. By way of example, the multiburst signal can be identified using the following procedure:

1. Does transition b occur within 8 samples of transition a?

2. Does transition b occur after transition a?

3. Does transition c occur within 34-106 samples of transition b?

4. Does transition c occur after transition b?

5. Does transition d occur within 8 samples of transition c?

6. Does transition d occur after transition c?

7. Does transition e occur within 34-106 samples of transition d?

8. Does transition e occur after transition d?

9. Are there at least 20 samples between transition e and transition f?

10. Does transition f occur after transition e?

If the answer to each of these questions is yes, the signal is identified as the multiburst signal.

Assuming that the luminance array is not identified as being derived from the multiburst signal, the arrays are then subjected to a coarse screening to determine whether further analysis should be undertaken. This is accomplished by examining the transitions of the luminance array through each slice level in pairs, each comprising a positive-going transition followed by a negative-going transition, and computing the number of sample points between the transitions of each pair. If the number of sample points between the transitions of the first pair of transitions is less than 66, corresponding to a time of 3.722 µs, then the luminance and chrominance arrays are examined to determine whether the 10T or 20T composite chrominance pulse is present. If the number of sample points is not less than 66 but is less than 256 (14.435 µs), and between 32 and 25 samples before the second transition the signal level was above the upper slice level, then the luminance array is examined for the stairs and bar signal elements; otherwise the line is excluded from further examination. If the number of sample points is more than 256, then the chrominance array is examined for the chrominance bar or three-level chrominance signal element.

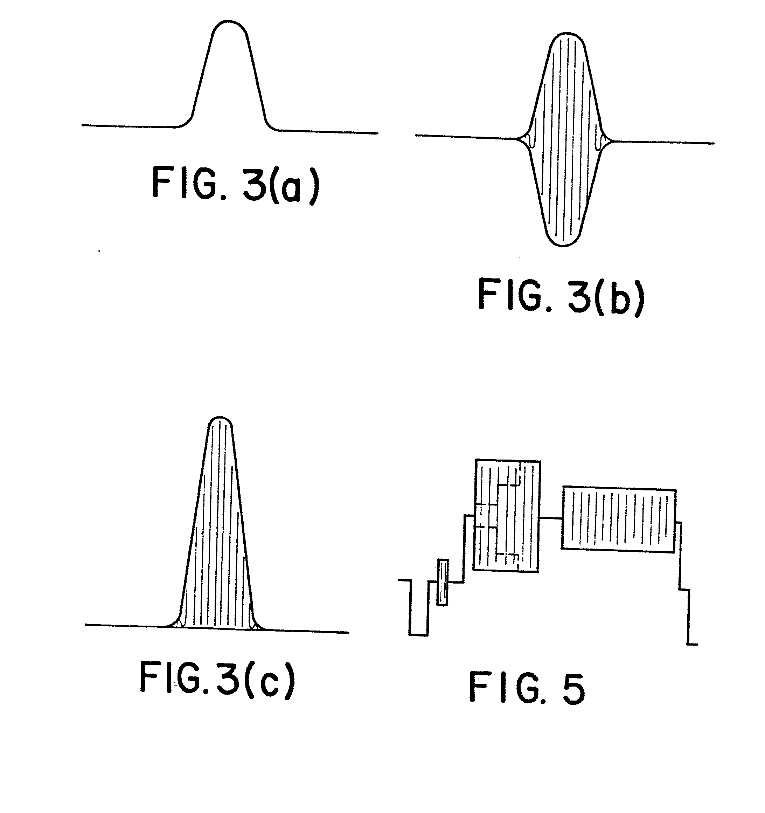

The 10T composite chrominance pulse (hereinafter referred to simply as the 10T pulse) is formed by adding a sine squared luminance pulse having a half-amplitude width of 1.00 µs (T=100 µs in the PAL system), as shown in FIG. 3(a), and a chrominance pulse having an envelope which is of sine squared form and has a half-amplitude width of 1.00 µs, as shown in FIG. 3(b) and a peak-to-peak amplitude equal to twice the amplitude of the luminance pulse. The resulting 10T pulse has the form shown in FIG. 3(c). The 20T pulse is the same as the 10T pulse, except that the half-amplitude width of each component is 2.0 µs. The chrominance array derived from the 10T pulse, using the bandpass operation with rectification, corresponds to the rectified envelope of the chrominance component, and the luminance array corresponds to the envelope of the 10T pulse. Thus, apart from possible delay between the chrominance and luminance components, the two arrays are each of the form of the sine squared luminance pulse shown in FIG. 3(a).

The presence of a 10T or 20T pulse is determined by first examining the luminance array and identifying the sample point k closest to the maximum amplitude of a feature of the array. Then, sample points on each side of the point k are examined to determine whether the shape of the feature is consistent with the feature's being a sine squared pulse having a half-amplitude width of 1.00 µs or 2.00 µs and not, for example, a bar. Assuming that the feature qualifies as a 10T or 20T pulse under this test (the 10T and 20T pulse being distinguished by their duration), the chrominance array is examined using similar principles to determine whether it includes a similar feature. Based on the result of these examinations of the luminance and chrominance arrays, a determination is made as to whether the selected line includes a 10T or 20T pulse. However, the line is not excluded from further examination simply because it includes a 10T or 20T pulse, because it might also include a step wedge or bar.

If the line has not yet been excluded from examination, it is then examined in similar manner to
identify signal elements which characterize the International test signal A, which is shown in FIG. 4 and
comprises the bar, 2T and luminance step wedge or
stairs.

The bar element is defined by an upward transition from blanking level (286 mv) to 1 volt, followed
by a downward transition from 1 volt to 286 mv at a
time 10 µs following the upward transition. In a preferred embodiment, the presence of the bar element on
the selected line must be qualified by the added
presence of the 2T sine-squared luminance pulse on the
same line (identified in similar manner to the 10T and
20T composite chrominance pulses) in order to conclude
that the bar test signal is present. It is not necessary to distinguish the bar from the multiburst flag,
because a signal which includes the multiburst flag
would have already been excluded from examination. The
bar may be distinguished from the luminance step wedge
by virtue of the long time delay between the transitions through the lower and upper slice levels on the
rising edge of the step wedge. The step wedge may be
distinguished from a ramp by use of an additional
routine, not part of this invention, whereby the locations of the individual steps of the step wedge are
identified.

If the preselected line has still not been qualified as a test signal, it is examined to identify the
chrominance bar (or three-level chrominance) signal
element, which characterizes the International test
signal D shown in FIG. 5. This examination is carried
out using the same principles as discussed above.

Portions of the source code listing for the preferred embodiment of the invention, written in Answer Basic, appear in the table. The source code operates using three principal scratch arrays SA, SB and SC. For the purposes of the present invention, the important members of the array SA are the members SA(1), SA(2) and SA(3), which represent the lower and upper slice levels and a normalizing constant, respectively. The normalizing constant for the ideal 1 volt normalized baseband signal would be 1mv, and from line 10280 of file SCNP35.BAS:

$$SA(1) = 250 \times SA(3)$$
$$SA(2) = 450 \times SA(3)$$

The array SB is a matrix having eight rows and eleven columns. The most important part of the matrix, for the purposes of the invention, is row seven, which is the same as row three. The eleven column entries in row seven relate respectively to the eleven signal elements that are to be identified pursuant to the invention. If the element associated with column X is found on a given line, SB (7,X) for that line is 1, and if the element X is not found, SB (7,X) is 0.

The important part of the array SC is SC(0) to SC(19). SC(0) to SC(9) represent the sample points for the first ten transitions through the lower slice level and SC(10) to SC(19) represent the sample points for the first ten transitions through the upper slice level. The command GOSUB 7000 in line 10150 of file SCAN5.BAS represents the sampling and digitizing of a preselected line (line N in the word STR[N]), and the repetition of that operation for the next seven frames. Lines 10160 and 10170 represent the derivation of the luminance and chrominance arrays, the commands SIN2BP and COSLP implementing the bandpass and rectification operation and the cosine lowpass operation respectively. Lines 10240, 10380 and 10390 of file SCNP15.BAS contain the operations for examining the scanning points of the lower and upper slice levels, SC(0), SC(1), SC(2) ... SC(9) and SC(10), SC(11), SC(12) ... SC(19), respectively, to identify a quiet line. Line 10250 contains the operations for identifying teletext or active video. Line 10260 and lines 10400 to 10450 relate to identification of the multiburst signal. Lines 10270 to 10330 represent the coarse screening that is done after examination for the multiburst signal. Line 10270 sets a value to A such that the first transition of a pair of successive transitions (in opposite directions) is positive going. Line 10280 attaches the argument B to the number of samples between the two transitions of a pair of transitions (of which the first is positive going). Line 10290 determines the action to be taken if B is less than 66, that is, advance to lines 10460 to 10520 and examine the arrays for the 10T and 20T pulses. If B is 66 or more, in line 10300 a decision is made as to whether the level of the luminance array immediately prior to the second transition is greater than the upper slice level, and if so the program advances to lines 10530 to 10780 and 10820 to search for the bar, 2T and stairs elements. In line 10310, if B is found to be less than 256 (in order to reach line 10310, B must be more than 66), the program advances to line 10350 and the next line of the video signal is examined. If B is 256 or more, the command TRNSCN in line 10320 is used to determine the number of transitions in the chrominance array (CA), and if the number of transitions exceeds a given value the program advances to lines 10780 to 10810, at which the routine for identifying the chrominance bar resides, and to lines 10830 to 10860, by which the three level chrominance element is identified. Lines 10860 to 10910 represent utility subroutines.

The procedure described above is used to scan each line of the vertical interval in turn and provide an output as to the signal elements identified on each line. In addition, the procedure may be used to provide updated information regarding the location, in the vertical interval, of particular signal elements. For example, it is conventional to provide certain test signals, and hence the signal elements of such test signals, on specific lines of the vertical interval, such as the multiburst signal on line 18, and accordingly the Tektronix 1980 is programmed to prefer examination of those specific lines for the signal elements of those particular test signals. By use of the present invention, information can be made available to the Tektronix 1980, in the event that a signal element is found on a different line, to update the location files so that the Tektronix 1980 will then examine the correct line.

It will be appreciated that, in the described method, each line of the vertical interval is examined to determine whether it contains specific signal elements, which characterize a test signal, instead of examining the entire line to determine whether its waveform conforms to that of a test signal. This principle is applied even in the case of the multiburst signal, but since the multiburst signal can be characterized by presence of the white flag only it is not necessary to identify any signal elements other than the flag. Thus, presence of the white flag is deemed a necessary and sufficient condition for the signal to be identified as the multiburst signal. In the preferred method, signal elements other than the white flag are identified separately, but it would be a simple matter to determine whether the elements of a given test signal, e.g., the International test signal A, are present on a given line, with the correct relative timing, and provide an output indicating that the test signal has been identified on that line.

It will be appreciated that the invention is not restricted to the particular procedure which has been described and illustrated, since variations may be made therein without departing from the scope of the invention as defined in the appended claims and equivalents thereof. For example, is not necessary to use the 250 mv and 450 mv slice levels which have been described, and the invention is not restricted to the use of two slice levels. In certain applications, three or more slice levels may be desirable, and in others a single slice level may be sufficient.

<div align="center">TABLE</div>

```
SCNP 35.BAS
*
*
*
10280     DIM
          SA(99)\SA(3)=GN/10.2*(ST(1)+1\SA(1)=250*SA(3)\
          SA(2)=450*SA(3)
*
*
*
SCAN 5.BAS
*
*
*
10150     SQ(SM,1)=N\GOSUB 7000\A$=STR(N)\IF
          LK$<>"LOCKED" THEN B$="S"
10160     SUMLNS VW(0:ST(1),0:1023),LA\SIN2BP
          VW(0:ST(1),0:1023),CA
10170     COSLP LA(0:1023)\STRATE LA(6:962)\MNSTDV
          LA(0:7),I\LA=LA-I
*
*
*
SCNP 15.BAS
*
*
*
10240     IF SC(10)<0 THEN IF SC(30)<0 THEN 10380
10250     TRNSCN
          VW(0,0:60),200*GN/10.2,1,1,6,SC(40:45)\IF
          SC(45)>0 THEN 10350
10260     GOTO
          SGN(SC(11))+SGN(SC(1))-SC(12)-SC(2)-SC(30)-4
          OF 10350\GOTO 10400
```

```
10270    GOTO SC(10)+2 OF 10350\A=10\IF
         LA(SC(A)+4)<SA(1) THEN A=11
10280    B=SC(A+1)-SC(A)\IF (SC(A)+1)*(SC(A+1)+1)=0
         THEN 10350
10290    IF B<66 THEN 10460
10300    MNSTDV LA(SC(A+1)-32:SC(A+1)-25),J\IF J>SA(2)
         THEN 10530
10310    IF B<256 THEN 10350
10320    TRNSCN CA(SC)(A)+8:
         SC(A)+360),35*SA(4),40,10,4,SC(40:43)
10330    IF SC(41)>0 THEN IF SB(7,0)=0 THEN 10790
10340    A=A+2\IF A<19 THEN 10280
10350    MINMAX SB(7,0:10),J,K\GOTO SB(7,J) OF
         10370\NEXT N
10360    F=F+313\G=G+313\IF F<600 THEN 10230
10370    PRINT\RETURN
10380    I=30\K=930\GOSUB 10710\IF J=0 THEN 10350\!
         QUIET
10390    GOTO SB(7,10) OF
         10350\SB(4,10)=N\SB(6,10)=-1\SB(7,10)=1\GOTO
         10350
10400    MINMAX SC(0:1),A,J\MINMAX
         SC(10:12),B,J\J=SGN(SC(A))+SGN(SC(B))\! MB
10410    J=J+SGN(8-SC(0)+SC(10))+SGN(SC(0)-SC(10))+SGN(
         8-SC(11)+SC(1))
10420    J=J+SGN(SC(1)-SC(0)-34)+SGN(SC(12)-SC(11)-34)+
         SGN(106-SC(1)+SC(0))
10430    J=J+SGN(106-SC(12)+SC(11))+SGN(SC(2))*SGN(SC(2
         )-SC(12)-20)
10040    GOTO SGN(ABS(J-10)) OF 10270\GOTO SB(7,6) OF
         10350
10450    SB(4,6)=N\SB(6,6)=-1\SB(7,6)=1\GOTO 10350
10460    GOTO SB(7,5) OF 10340\MINMAX
         LA(SC(A):SC(A+1)),K,K\! 10T/20T
```

```
10470  MNSTDV LA(K-43:K-40),I\IF ABS(I)>28*GN THEN
       10340
10480  MINMAX CA(K-40:K+40),J,J\IF CA(J)<300*SA(4)
       THEN 10340
10490  LVLSCN CA(K-40:K+40),CA(J)*4/7,10,2,SC(40:41)
10500  SA(10:11)=ABS(SC(A:A+1)-SC(40:41))\MINMAX
       SA(10:11),I,J
10510  GOTO SGN(SA(J)-12) OF
       10340\SB(4,5)=N\SB(5,5)=(SGN(27.5-B)+1)/2
10520  I=K\GOSUB 10860\SB(6,5)=I\SB(7,5)=1\GOTO
       10340
10530  K=SC(A+1)-443\IF K<0 THEN K=0\! STAIRS, BAR,
       2T,BLANK & BASE REF.
10540  TRNSCN
       LA(K:SC(A+1)+10),J/10,28,8,6,SC(40:45),-1\IF
       SC(44)<0 THEN 10340
10550  SA(10:11)=SGN(ABS(SC(44:45)-SC(A:A+1))-7)\IF
       SA(11)>0THEN 10340
10560  GOTO SA(10) OF 10730\GOTO SB(7,1) OF 10340\IF
       J>SA(5) THEN 10340
10570  LVLSCN
       CA(CS(A)-10:SC(A+1)+10),SA(6)/3,10,2,SC(40:41)

10580  GOTO SGN(SC(40)) OF 10340
10590  TRNSCN
       LA(0:962),310*SA(3),2,2,20,SA(30:49)\MINMAX
       SA(32:49),J,K
10600  SA(10:J-22)=SA(31:J-1)-SA(30:J-2)\MINMAX
       SA(10:J-22),J,K\K=J+20
10610  If (SGN(SA(J)-2)+1)*(SGN(SA(J)-9)-1)=0 THEN
       10340
10620  MINMAX CA(SA(K)-3:SA(K+1)+3),M,M\IF
       CA(M)<SA(6) THEN 10340
10630  I=SA(K)-12\K=3\GOSUB 10710\IF J=0 THEN 10340
```

```
10640    I-SC(A)\GOSUB 10860\SB(6,1)=I\I=M\GOSUB
         10860\SB(6,4)=I\K=15
10650    SB(5,1)=ITP(10*B*TS/1000+.5)/10\FOR M=2
         TO3\I=(M-2)*(SB(6,1)+SB(5,1)+2)
10660    GOSUB
         10870\SA(95)=8*ITP(I/8)+7\SA(90)=SA(95)\SA(91)
         =25*SA(3)
10670    I=SB(2,M)\GOSUB 10870\IF I>SA(95) THEN IF
         I<951 THEN SA(90)=I
10680    SA(92:94)=0\GOSUB 10890\GOTO SA(94) OF
         10700\FOR I=SA(95) TO 951 STEP 8
10690    GOSUB 10890\NEXT I\GOTO SA(94) OF
         10700\SB(7,1:4)=0\GOTO 10340
10700    I=SA(93)\GOSUB 10860\SB(6,M)=I\NEXT
         M\SB(7,1:4)=1\SB(4,1:4)=N\GOTO 10340
10710    MNSTDV LA(I:I+K),J\IF ABS(J)>25*SA(3) THEN
         J=0\RETURN
10720    MINMAX
         CA(I:I+K),J,J\J=ITP(SGN(60*SA(4)-CA(J))+1)/2)\
         RETURN
10730    ! STAIRS
10740    SA(10:13)=SC(41:44)-SC(40:43)\MNSTDV
         SA(10:13),J,K\IF K>4 THEN 10340
10750    GOTO SC(40)+2 OF 10340\MINMAX
         CA(SC(40):SC(44)),J,K
10760    K=7+(SGN(CA(J)-SA(6)/3)+1)/2\GOTO SB(7,K) OF
         10340\SB(4,K)=N
10770    SB(7,K)=1\IF K=7 THEN I=SC(40)\GOSUB
         10860\SB(6,K)=I\GOTO 10340
10780    I=SC(40)\GOSUB 10860\SB(6,K)=I\GOTO 10340
10790    IF SGN(SC(11))-SC(12)-SC(0)<>3 THEN 10340\! G
10800    TRNSCN
         CA(SC(10)+8:SC(31)+20),35*SA(4),40,10,5,SC(42:
         46)
```

```
10810    GOTO SGN(SC(46)) OF
         10340\B=SGN(40-ABS(SC(45)-SC(31)))\GOTOB OF
         10830
10820    B=0\GOTO SGN(40-ABS(SC(43)-SC(31))) OF
         10850\GOTO 10340
10830    SC(42:44)=SC(43:45)-SC(42:44)\SC(44)=2*SC(44)/
         3\MNSTDV SC(42:44),J,J
10840    GOTO SGN(J-20) OF 10340
10850    SB(4,9)=N\SB(5,9)=B\I=SC(10)\GOSUB
         10860\SB(6,9)=I\SB(7,9)=1\GOTO 10350
10860    I-ITP(10*(I+SQ(SM,0)-18)*TS/1000+.5)/10\RETURN

10870    I-ITP(I*1000/TS+.5)-SQ(SM,0)+18
10880    I=I-7\I=7+I*SGN(1+SGN(I))\I=I-1015\I=1015+I*SG
         N(1-SGN(I))\RETURN
10890    MINMAX CA(I-7:I+8),K,K\MNSTDV
         LA(I-7:I+8),J\IF CA(K)>60*SA(4) THEN 10920
10900    K=(1+SGN(I-SA(90)))/2\K=951*K\K=TAN(1.1-2.2*(I
         -K)/(SA(90)-K))
10910    J=ABS(J)-SA(91)/4*(2-K)\IF J<SA(92) THEN
         SA(92)=J\SA(93)=I\SA(94)=1
10920    RETURN
```

CLAIMS

1. A method of determining whether an acquired signal includes at least one predetermined signal element, comprising the steps of identifying the relative time occurrences of transitions of the acquired signal through at least one predetermined signal level, and comparing the identified relative time occurrences with predetermined rules governing the relative time occurrences of transitions of the signal element through said predetermined signal level.

2. A method according to claim 1, wherein the step of identifying the relative time occurrences of the transitions of the acquired signal through a predetermined signal level is performed by sampling the signal, and identifying consecutive samples which have levels which are, respectively, greater than said predetermined signal level and less than said predetermined signal level.

3. A method according to claim 2, wherein the samples are digitized and the step of identifying the relative time occurrences of transitions of the acquired signal through a predetermined signal level is accomplished by comparing the digital values of the levels of the samples with the digital value of the predetermined signal level.

4. A method according to claim 1, wherein the signal element is an element of a vertical insertion test signal and the acquired signal is a signal derived from one of the lines of the vertical interval of a composite video signal.

5. A method according to claim 4, wherein the acquired signal is a signal selected from the group consisting of the chrominance signal and the luminance signal, obtained from the composite video signal by filtering.

6. A method according to claim 4, comprising the step of providing an output signal indicating that the acquired signal includes the predetermined signal element if the identified time occurrences conform to said predetermined rules.

7. A method according to claim 4, comprising the steps of determining whether the acquired signal includes a plurality of signal elements corresponding to the signal elements of a standard test signal and, if it does, providing an output signal indicating that the acquired signal is said standard test signal.

FIG. 1

FIG. 2

FIG. 4

FIG. 3(a)

FIG. 3(b)

FIG.3(c)

FIG. 5

European Patent
Office

**0142842**

. Application number

**EUROPEAN SEARCH REPORT**

EP   84 11 3920

## DOCUMENTS CONSIDERED TO BE RELEVANT

| Category | Citation of document with indication. where appropriate, of relevant passages | Relevant to claim | CLASSIFICATION OF THE APPLICATION (Int. Cl.4) |
|---|---|---|---|
| X | GB-A-2 094 010  (SECRETARY OF STATE FOR DEFENCE) <br> * Page  1,  lines 39-47; page 2, lines 23-105; figures 1,2 * | 1-3 | G 01 R   29/033 <br> H 04 N   17/00 |
| A | DE-A-2 821 887  (INSTITUT FÜR RUNDFUNKTECHNIK) <br> * Page  5, line 9 - page 8, line 5; figures 1-5 * | 1-4 | |
| A | US-A-4 240 100  (GORBOLD) <br> * Column  2, lines 36-62; column 21, lines 42-47; figure 1 * | 1 | |
| A | DE-A-2 919 620  (SIEMENS) <br> * Page  9,  lines 5-23; page 12, lines 20-25; figures 1,2 * | 1 | |

TECHNICAL FIELDS
SEARCHED (Int. Cl 4)

H 04 N   17/00
H 04 N   17/02
G 01 R   29/027
G 01 R   29/033

The present search report has been drawn up for all claims

| Place of search <br> THE HAGUE | Date of completion of the search <br> 25-01-1985 | Examiner <br> YVONNET J.W. |
|---|---|---|